# EUROPEAN PATENT APPLICATION

(11) **EP 1 146 636 A1**
(43) Date of publication of application: **17.10.2001**
(21) Application number: 01108027.2
(22) Date of filing: 29.03.2001
(51) Int. Cl.: H03G 1/04

(54) **Radio transmitter with reduced power consumption**

(30) Priority: 31.03.2000 JP 2000099515
(71) Applicant: MITSUBISHI DENKI KABUSHIKI KAISHA, Tokyo 100-8310 (JP)
(72) Inventor: Mochizuki, Mitsuru, Chiyoda-ku, Tokyo 100-8310 (JP); Niwano, Kazuhito, Chiyoda-ku, Tokyo 100-8310 (JP); Nakayama, Masatoshi, Chiyoda-ku, Tokyo 100-8310 (JP); Mori, Kazutomi, Chiyoda-ku, Tokyo 100-8310 (JP); Shinjo, Shintaro, Chiyoda-ku, Tokyo 100-8310 (JP); Fukuyama, Shinjiro, Chiyoda-ku, Tokyo 100-8310 (JP); Matsunami, Yoshinori, Chiyoda-ku, Tokyo 100-8310 (JP); Sakuma, Naoyuki, Chiyoda-ku, Tokyo 100-8310 (JP)
(74) Representative: Bohnenberger, Johannes, Dr.

(57) **Abstract**

A radio transmitter includes a gain compensation controller (9) that derives the gain variation of the power amplifier (7) from its bias voltage determined in response to its desired output power level, and that derives the control voltage of at least one of variable gain amplifiers (21, 3, 4 and 6) from the gain variation. A variable gain amplifier gain controller (10) applies the control voltage to the variable gain amplifier, thereby compensating for the gain variation of the power amplifier. The radio transmitter can solve a problem of a conventional radio transmitter in that it is unavoidable for the power amplifier to bring about the gain variation when its bias voltage is varied in response to the output power level.

## Description

### BACKGROUND OF THE INVENTION

### Field of the Invention

The present invention relates to a radio transmitter incorporated into a mobile communications terminal, for example, for transmitting various signals, and particularly to a radio transmitter with reduced power consumption.

### Description of Related Art

A mobile communications system carries out transmission power control considering an increasing number of terminals simultaneously connected and interference with other stations, thereby suppressing unnecessary transmission power of a mobile communications terminal. In particular, a CDMA (Code Division Multiple Access) mobile communications system must implement highly accurate transmission power control over a wide dynamic range. On the other hand, to prolong a period of a battery by saving its power, it is necessary for the terminal to reduce the power consumption of its transmitting power amplifier.

Since such a transmitting power amplifier of the terminal employs a linear amplifier operating as almost a class AB amplifier, the ratio of the transmission power to the power consumption is reduced as the output power of the transmitting power amplifier reduces.

Conventionally, to increase the power efficiency at low output power, a radio transmitter is proposed that controls the bias voltage value of the power amplifier in response to its output power.

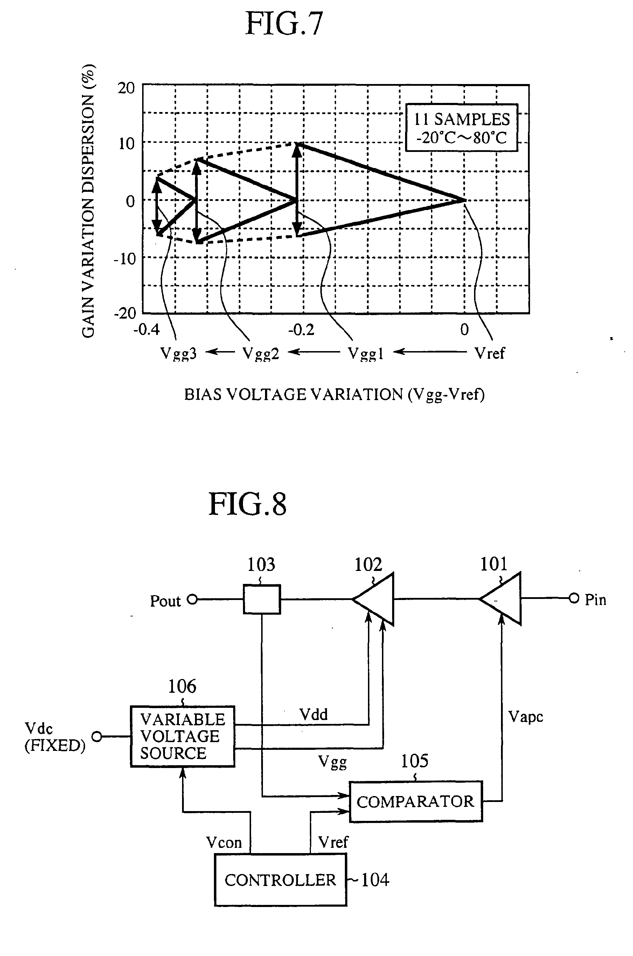

Fig. 8 is a block diagram showing a configuration of such a conventional radio transmitter disclosed in Japanese patent application laid-open No. 7-170202/1995, for example. In this figure, the reference numeral 101 designates a variable gain amplifier; 102 designates a power amplifier for amplifying the output of the variable gain amplifier 101; and 103 designates a signal extraction detector for detecting the output power of the power amplifier.

The reference numeral 104 designates a controller for outputting a reference voltage Vref for specifying the output power level of the power amplifier 102, and for outputting a voltage source control signal Vcon corresponding to the reference voltage Vref; 105 designates a comparator for generating a gain control voltage Vapc supplied to the variable gain amplifier 101 in response to the output of the signal extraction detector 103 and the reference voltage Vref; and 106 designates a variable voltage source for supplying the power amplifier 102 with bias voltages Vdd and Vgg corresponding to the voltage source control signal Vcon.

Next, the operation of the conventional radio transmitter will be described.

The controller 104 supplies the comparator 105 with the reference voltage Vref corresponding to a desired output power level. On the other hand, the signal extraction detector 103 computes the present output power level of the power amplifier 102, and supplies it to the comparator 105. The comparator 105 compares the two levels, and supplies the variable gain power amplifier 101 with the gain control voltage Vapc corresponding to the difference between the two levels to zero the difference.

Therefore, the output power level of the power amplifier 102 can be varied by the reference voltage Vref.

Furthermore, the controller 104 supplies the variable voltage source 106 with the voltage source control signal Vcon corresponding to the reference voltage Vref to improve the power efficiency of the power amplifier 102. In response to the voltage source control signal Vcon, the variable voltage source 106 generates the bias voltages (power supply voltage Vdd and gate voltage Vgg) to be supplied to power amplifier 102 from the constant voltage source Vdc.

Thus, the bias voltages (power supply voltage Vdd and gate voltage Vgg) supplied to the power amplifier 102 can be varied by controlling the voltage source control signal Vcon in response to the reference voltage Vref. In other words, varying the reference voltage Vref can vary the output power level of the power amplifier 102, along with the bias voltages Vdd and Vgg of the power amplifier 102.

For example, the bias voltage Vdd of the power amplifier 102 is increased when the output power level of the power amplifier 102 is large, and is decreased when the output power level is low. Thus setting the bias voltage Vdd at a low level within a range that satisfies a desired distortion characteristic in response to the output power level enables the power consumed by the power amplifier 102 to be reduced, thereby improving the power efficiency.

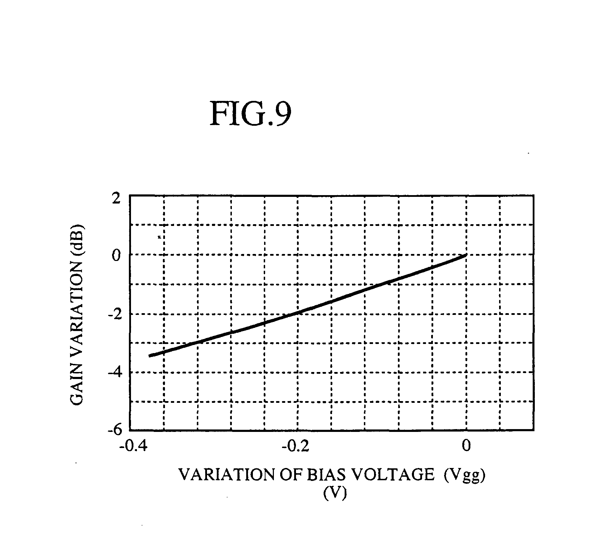

Generally, however, the DC voltage-current characteristic and DC current gain characteristic of a semiconductor amplification device used as the power amplifier vary according to the bias voltages applied. Accordingly, the gain of the operating power amplifier varies depending on the bias voltages applied. Fig. 9 is a diagram illustrating a gain variation characteristic against the variation of the bias voltage Vgg of the power amplifier. As illustrated in Fig. 9, as the bias voltage Vgg varies, the gain of the power amplifier varies. A similar phenomenon takes place for the variation in the bias voltage Vdd of the power amplifier.

As other conventional radio communications apparatuses, there are those disclosed in Japanese patent application laid-open No. 1-314431/1989, Japanese patent application laid-open No. 3-35620/1991, and Japanese patent application laid-open No. 4-277909/1992.

With the foregoing configuration, the conventional radio transmitter has a problem involved in the transmission power control in that it is difficult for the power amplifier 102 to control its output power accurately because when its bias voltage is varied in response to the output power level of the power amplifier 102, it is unavoidable that its gain also varies, and hence the output power level of the power amplifier 102 deviates from a desired level.

### SUMMARY OF THE INVENTION

The present invention is implemented to solve the foregoing problem. It is therefore an object of the present invention to provide a radio transmitter capable of controlling its output power accurately by compensating for the gain variation due to the bias voltage variation of the power amplifier by adjusting the gain of the variable gain amplifier.

Another object of the present invention is to provide a radio transmitter that can reduce, when compensating for the gain variation involved in the bias voltage variation of the power amplifier, individual dispersion in the gain variation of the power amplifier and individual dispersion in its temperature characteristic by adjusting the bias voltage of the power amplifier at least at two steps.

Still another object of the present invention is to provide a radio transmitter capable of reducing individual dispersion in the gain variation of the power amplifier and individual dispersion in its temperature characteristic, by deriving the idle current of the power amplifier from the output power of the power amplifier, by calculating the bias voltage to be applied to the power amplifier and the gain of the variable gain amplifier from the idle current, and by setting them to the power amplifier and to the variable gain amplifier, thereby compensating for the gain variation of the power amplifier involved in controlling the bias voltage of the power amplifier.

Another object of the present invention is to provide a radio transmitter that can reduce, when compensating for the gain variation due to the bias voltage variation of the power amplifier, the individual dispersion in the gain variation of the power amplifier and individual dispersion in its temperature characteristic by varying the idle current of the power amplifier at least at two steps.

According to one aspect of the present invention, there is provided a radio transmitter comprising: a power amplifier; a variable gain amplifier connected in series with the power amplifier; bias voltage apply means for applying a bias voltage to the power amplifier; gain control means for controlling a gain of the variable gain amplifier; bias voltage control means for controlling the bias voltage of the power amplifier; and compensation means for compensating a gain variation of the power amplifier involved in controlling the bias voltage of the power amplifier by controlling the gain of the variable gain amplifier.

Here, the bias voltage control means may control the bias voltage of the power amplifier in response to desired output power of the power amplifier.

The compensation means may comprise information about relationships between the desired output power of the power amplifier and the bias voltage of the power amplifier, and information about relationships between the bias voltage of the power amplifier and the gain of the variable gain amplifier.

The compensation means may compensate for the gain variation of the power amplifier involved in controlling the bias voltage of the power amplifier, by deriving idle current of the power amplifier from desired output power of the power amplifier, by deriving the bias voltage of the power amplifier and the gain of the variable gain amplifier from the idle current of the power amplifier, and by supplying the bias voltage control means and the gain control means with the bias voltage and gain derived.

The compensation means may comprise information about relationships between the desired output power of the power amplifier and the idle current of the power amplifier, information about relationships between the idle current of the power amplifier and the gain of the variable gain amplifier, and information about relationships between the idle current of the power amplifier and the bias voltage of the power amplifier.

The bias voltage of the power amplifier may be varied at least at two steps.

### BRIEF DESCRIPTION OF THE DRAWINGS

Fig. 1 is a block diagram showing a configuration of an embodiment 1 of the radio transmitter in accordance with the present invention;
Fig. 2 is a block diagram showing a configuration of a power amplifier bias voltage controller and a gain compensation controller of an embodiment 2 of the radio transmitter in accordance with the present invention;
Fig. 3 is a block diagram showing a configuration of an embodiment 3 of the radio transmitter in accordance with the present invention;
Fig. 4 is a diagram illustrating an example of measured results of the relationships between the bias voltage variation ΔVgg and the dispersion of the gain variation of a common power amplifier;
Fig. 5 is a diagram illustrating an example of measured results of the relationships between the idle current variation ΔIdo and the dispersion of the gain variation of the common power amplifier;
Fig. 6 is a block diagram showing a configuration of an embodiment 4 of the radio transmitter in accordance with the present invention;
Fig. 7 is a diagram illustrating an example of measured results of the relationships between the bias voltage variation ΔVgg and the dispersion of the gain variation of the power amplifier 7 in an embodiment 5 of the radio transmitter in accordance with the present invention;
Fig. 8 is a block diagram showing a configuration of a conventional radio transmitter; and
Fig. 9 is a diagram illustrating an example of the gain variation characteristic against the variation in the bias voltage Vgg of a power amplifier.

### DETAILED DESCRIPTION OF THE PREFERRED EMBODIMENTS

The invention will now be described with reference to the accompanying drawings.

### EMBODIMENT 1

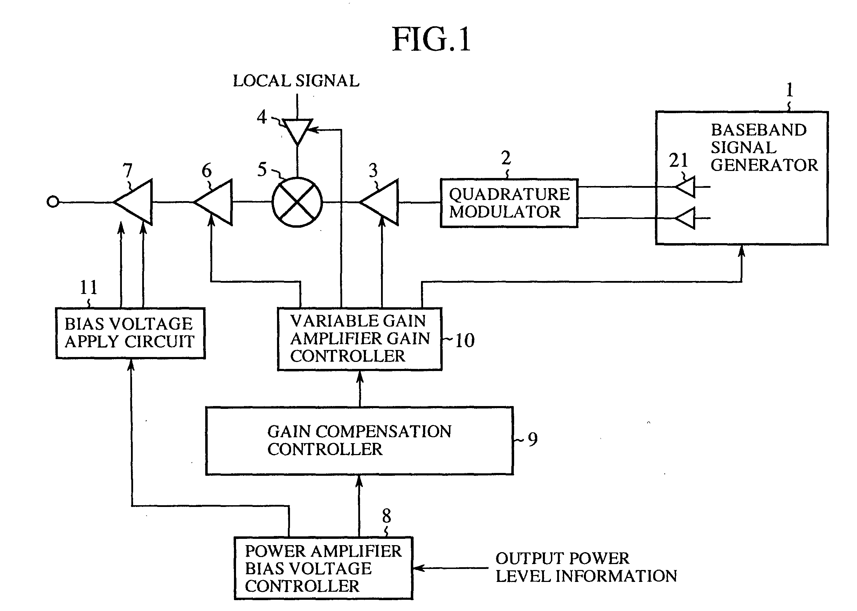

Fig. 1 is a block diagram showing a configuration of an embodiment 1 of the radio transmitter in accordance with the present invention. In this figure, the reference numeral 1 designates a baseband signal generator including variable gain amplifiers 21 for amplifying baseband signals; 2 designates a quadrature modulator for carrying out quadrature modulation of the two baseband signals; 3 designates a variable gain amplifier for amplifying the signal modulated by the quadrature modulator 2; 4 designates a variable gain amplifier for amplifying a local signal; 5 designates a mixer for mixing the signal amplified by the variable gain amplifier 3 with the local signal, thereby converting it to a radio frequency signal; 6 designates a variable gain amplifier for amplifying the radio frequency signal generated by the mixer 5; and 7 designates a power amplifier for amplifying the signal amplified by the variable gain amplifier 6.

The reference numeral 8 designates a power amplifier bias voltage controller for determining the bias voltage to be applied to the power amplifier 7 from the information about the power level of the output signal (output power level information) of the power amplifier 7; 9 designates a gain compensation controller for instructing a change of the gain of at least one of the variable gain amplifiers 21, 3, 4 and 6 for compensating for the gain variation due to the change in the bias voltage of the power amplifier 7; 10 designates a variable gain amplifier gain controller for controlling the gain of at least one of the variable gain amplifiers 21, 3, 4 and 6; and 11 designates a bias voltage apply circuit for applying the bias voltage determined by the power amplifier bias voltage controller 8 to the power amplifier 7.

Next, the operation of the present embodiment 1 will be described.

The baseband signals are generated by the baseband signal generator 1, amplified by the variable gain amplifiers 21 included in the generator, and modulated by the quadrature modulator 2. The modulation signal generated by the quadrature modulator 2 is amplified by the variable gain amplifier 3 with the gain set by the variable gain amplifier gain controller 10. The amplified signal is mixed with the local signal by the mixer 5 to the radio frequency signal.

Then, the variable gain amplifier 6 amplifies the radio frequency signal with the gain set by the variable gain amplifier gain controller 10.

The output power control of the system is carried out by controlling the gain of at least one of the variable gain amplifiers 21, 3, 4 and 6.

The output power level information of the power amplifier 7 is supplied to the power amplifier bias voltage controller 8 that sets at least one of the bias voltages Vdd and Vgg of the power amplifier 7 according to a desired output power level, supplies the bias voltage value to the bias voltage apply circuit 11. The bias voltage apply circuit 11 applies the bias voltages Vdd and Vgg to the power amplifier 7. Varying at least one of the bias voltages according to the desired output power level enables the power amplifier 7 to reduce its power consumption.

The gain compensation controller 9, receiving the information about at least one of the bias voltages Vdd and Vgg of the power amplifier 7 from the power amplifier bias voltage controller 8, detects the variation in the bias voltage of the power amplifier 7 from the information, calculates the gain variation from the variation in the bias voltage of the power amplifier 7, and compensates for the gain variation by adjusting the gain of at least one of the variable gain amplifiers 21, 3, 4 and 6.

Specifically, as for at least one of the variable gain amplifiers 21, 3, 4 and 6, the gain compensation controller 9 supplies the variable gain amplifier gain controller 10 with a control voltage value required to implement the desired output power level by compensating for the gain variation. Thus, the variable gain amplifier gain controller 10 supplies the variable gain amplifier with the control voltage that enables the variable gain amplifier to control its gain in response to the control voltage value.

As described above, the present embodiment 1 compensates for the gain variation due to the bias voltage variation of the power amplifier 7 by adjusting the gain of the variable gain amplifier. Thus, it offers an advantage of being able to reduce the power consumption of the power amplifier 7, and to control the output power at high accuracy.

### EMBODIMENT 2

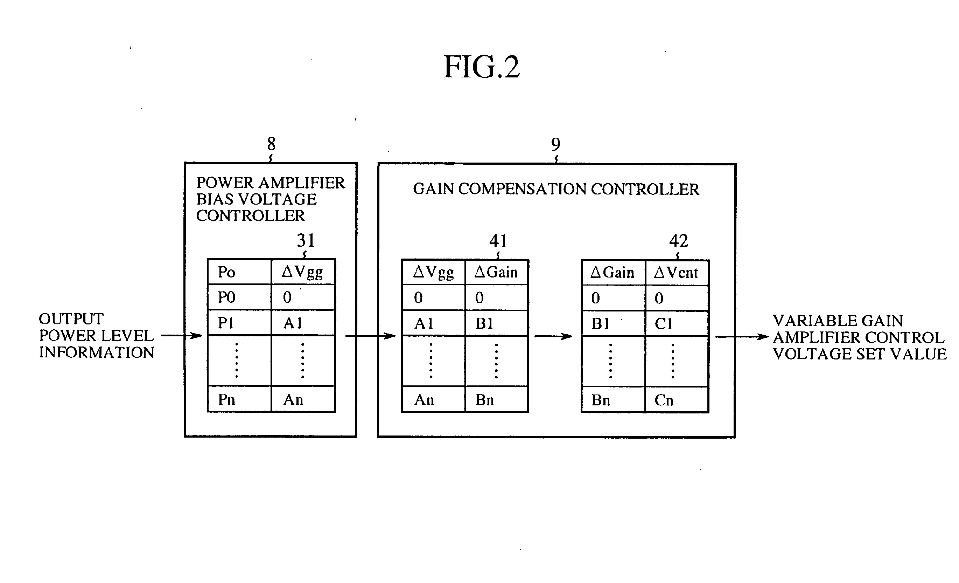

Fig. 2 is a block diagram showing a configuration of the power amplifier bias voltage controller 8 and the gain compensation controller 9 of an embodiment 2 of the radio transmitter in accordance with the present invention. In this figure, the reference numeral 31 designates a ROM table incorporated into the power amplifier bias voltage controller 8 for indicating the relationships between the desired output power level and the bias voltage variation ΔVgg of the power amplifier 7. The reference numeral 41 designates a ROM table incorporated in the gain compensation controller 9 for indicating the relationships between the bias voltage variation ΔVgg and the gain variation ΔGain of the power amplifier 7; and 42 designates a ROM table incorporated into the gain compensation controller 9 for indicating the relationships between the gain variation ΔGain and the control voltage variation ΔVcnt of at least one of the variable gain amplifiers.

Since the remaining configuration of the embodiment 2 of the radio transmitter is the same as that of the embodiment 1, the description thereof is omitted here.

Next, the operation of the present embodiment 2 will be described.

Referring to the ROM table 31, the power amplifier bias voltage controller 8 captures the bias voltage variation ΔVgg of the power amplifier 7 corresponding to the desired output power level information.

On the other hand, the gain compensation controller 9, referring the ROM table 41 in response to the bias voltage variation ΔVgg of the power amplifier 7 fed from the power amplifier bias voltage controller 8, captures the gain variation ΔGain corresponding to the bias voltage variation. Subsequently, referring to the ROM table 42, the gain compensation controller 9 captures the control voltage variation ΔVcnt of the variable gain amplifier corresponding to the gain variation ΔGain, calculates the control voltage set value of the variable gain amplifier from the control voltage variation ΔVcnt, and supplies it to the variable gain amplifier gain controller 10.

The variable gain amplifier gain controller 10 supplies the control voltage designated by the control voltage set value to the variable gain amplifier, thereby varying the gain of the variable gain power amplifier, and compensating for the gain variation of the power amplifier 7.

The ROM tables 41 and 42 record information obtained by measuring the bias voltage variation and gain variation, and the gain variation and the control voltage value in advance.

Although the ROM tables store the relationships between the variations of the characteristic values in the present embodiment 2, they can store the absolute values of the characteristic values instead.

In addition, although the present embodiment 2 utilizes the bias voltage Vgg of the power amplifier 7 for the control, it can use the bias voltage Vdd instead.

Although the present embodiment 2 captures the control voltage value from the bias voltage using the ROM tables 41 and 42, this is not essential. For example, the gain compensation controller 9 can calculate the control voltage value from the bias voltage according to functions approximating the relationships between the characteristic values instead of incorporating the ROM tables 41 and 42.

The functions can be obtained by measuring the relationships between the bias voltage and the gain variation, and between the gain variation and the control voltage, and by carrying out the function approximation of the measured results. The function approximation can eliminate the ROM tables 41 and 42, and hence reduce the capacity of the ROM necessary for the present system.

As described above, since the present embodiment 2 prestores the information about the relationships between the characteristic values using the ROM tables or functions, it can obviate the signal extraction detector for detecting the output power of the power amplifier 7 and the circuit for feeding the output power back to the control voltage during the output power control. Thus, in addition to the advantages of the embodiment 1, it offers an advantage of being able to simplify the configuration of the system, and to shorten the control time.

Besides, although it is usually difficult to configure a wide dynamic range detector, since the present embodiment 2 does not use the detector, it offers an advantage of being able to carry out the output power control over a wide dynamic range at high accuracy.

### EMBODIMENT 3

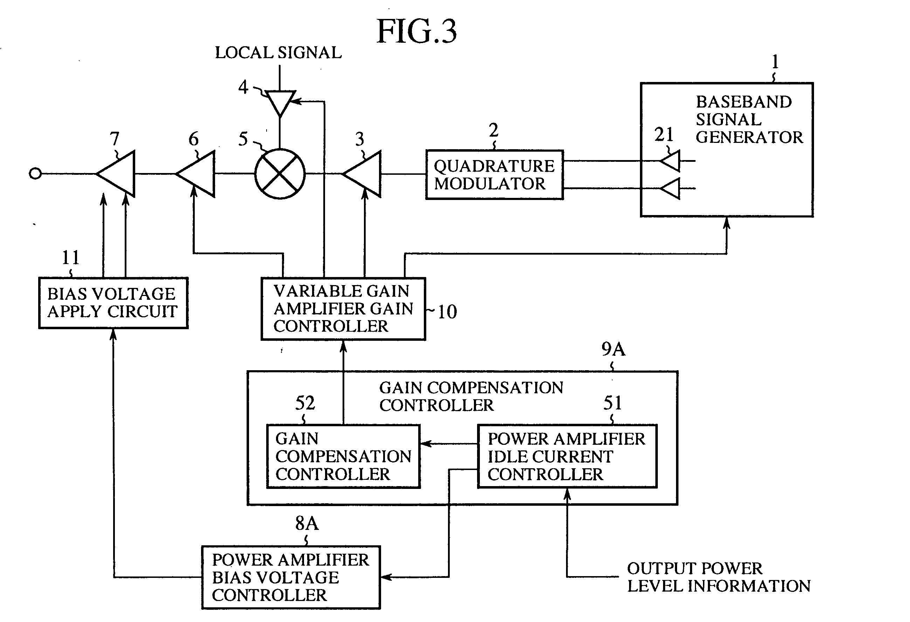

Fig. 3 is a block diagram showing a configuration of an embodiment 3 of the radio transmitter in accordance with the present invention. In this figure, the reference numeral 8A designates a power amplifier bias voltage controller for determining the bias voltages to be applied to the power amplifier 7 in response to the idle current of the power amplifier 7 (the current when no input signal is supplied to the power amplifier 7); and 9A designates a gain compensation controller that comprises a power amplifier idle current controller 51 and a gain compensation controller 52, and instructs to vary the gain of at least one of the variable gain amplifiers 21, 3, 4 and 6 in response to the output power level information of the power amplifier 7, considering the gain variation due to the bias voltage variation of the power amplifier 7. Here, the power amplifier idle current controller 51 sets the idle current of the power amplifier 7 in response to the output power level information of the power amplifier 7, and the gain compensation controller 52 calculates the gain of at least one of the variable gain amplifiers from the idle current of the power amplifier 7.

Since the remaining components of Fig. 3 are the same as those of the embodiment 1, the description thereof is omitted here.

Next, the operation of the present embodiment 3 will be described.

The power amplifier idle current controller 51 derives the idle current of the power amplifier 7 from the output power level information that specifies its output power level, supplies the idle current information to the gain compensation controller 52, and supplies the bias voltage variation of the power amplifier 7 corresponding to the idle current to the power amplifier bias voltage controller 8A.

Deriving the gain variation of the power amplifier 7 corresponding to the idle current, the gain compensation controller 52 calculates the gain variation of at least one of the variable gain amplifiers required to compensate for the gain variation of the power amplifier 7, thereby deriving the gain control voltage value of the variable gain amplifier, and supplies it to the variable gain amplifier gain controller 10.

On the other hand, the power amplifier bias voltage controller 8A sets the bias voltage value corresponding to the bias voltage variation, and supplies it to the bias voltage apply circuit 11. Thus varying the bias voltage in response to the desired output power level via the idle current can reduce the power consumption of the power amplifier 7.

Since the remaining operation is the same as that of the foregoing embodiment 1, the description thereof is omitted here.

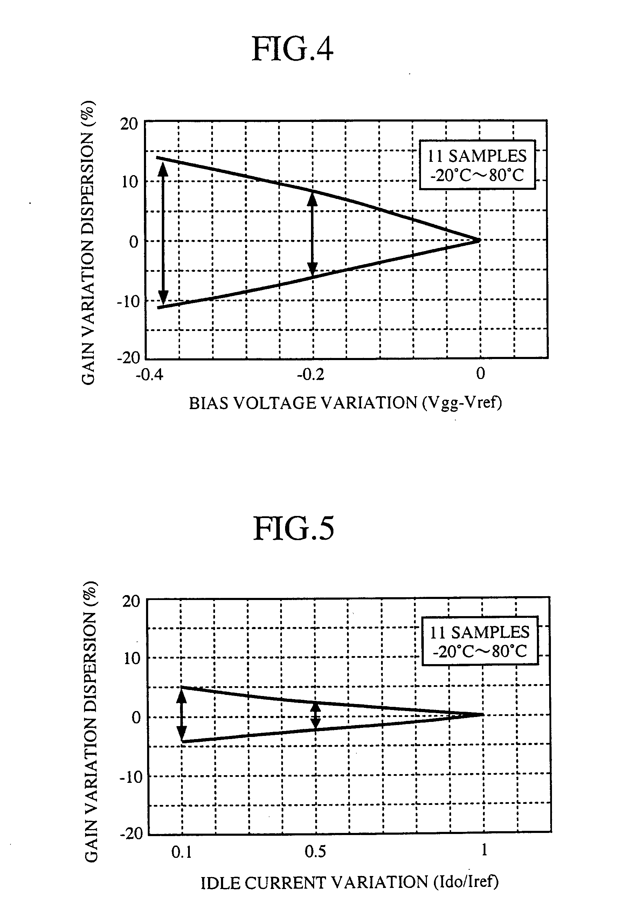

Fig. 4 is a diagram illustrating an example of measured results of the relationships between the bias voltage variation ΔVgg and the dispersion of the gain variation of a common power amplifier; and Fig. 5 is a diagram illustrating an example of measured results of the relationships between the idle current variation ΔIdo and the dispersion of the gain variation of the common power amplifier.

In the measurement, 11 samples are used, and the temperature is varied between -20 and 80 degrees centigrade for each sample. Figs. 4 and 5 illustrates the measured results with maximum dispersions, in which Vref and Iref denote the reference bias voltage and the reference idle current before the changes.

As illustrated in Fig. 4, when the bias voltage is varied greatly, the gain variation against the bias voltage variation ΔVgg varies sharply. On the other hand, as illustrated in Fig. 5, when the idle current variation ΔIdo is varied, the dispersion of the gain variation of the power amplifier 7 is smaller than that when the bias voltage variation ΔVgg is varied.

Therefore, the dispersion of the individual power amplifiers and the dispersion of the temperature characteristics will become smaller by deriving the gain variation from the idle current of the power amplifier 7 than deriving it from the bias voltage of the power amplifier 7.

As described above, the present embodiment 3 derives the idle current of the power amplifier 7 from the output power of the power amplifier 7; calculates the bias voltage to be supplied to the power amplifier 7 and the gain of at least one of the variable gain amplifiers from the idle current of the power amplifier 7; and compensates for the gain variation of the power amplifier 7 due to the control of its bias voltage. Thus, in addition to the advantages of the foregoing embodiment 1, the present embodiment 3 offers an advantage of being able to reduce the individual dispersions of the gain variation of the power amplifier 7 and the individual dispersions of the temperature characteristic.

### EMBODIMENT 4

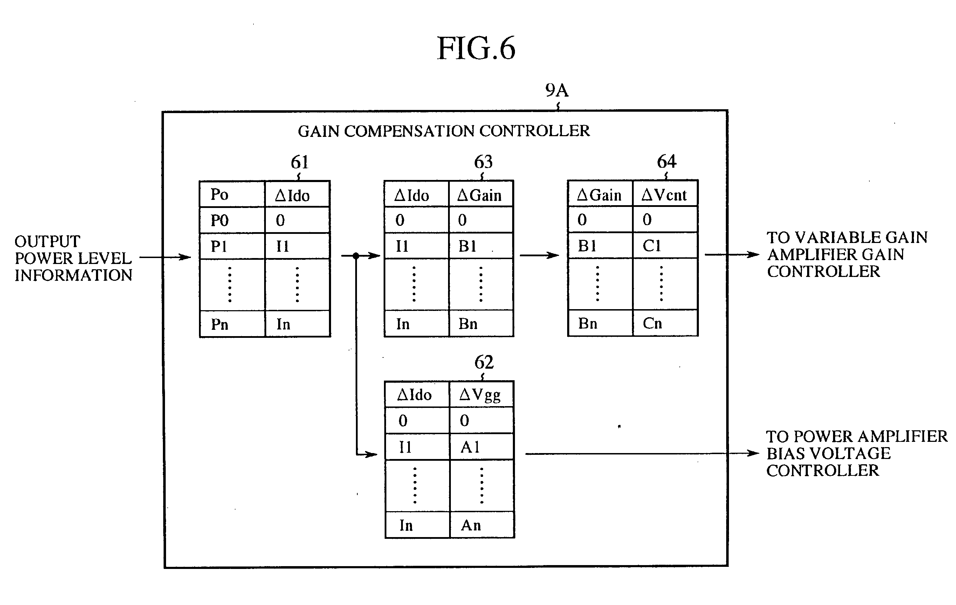

Fig. 6 is a block diagram showing a configuration of the gain compensation controller 9A of an embodiment 4 of the radio transmitter in accordance with the present invention. In this figure, the reference numeral 61 designates a ROM table incorporated in the gain compensation controller 9A, for indicating the relationships between the output power level and the idle current variation ΔIdo of the power amplifier 7; 62 designates a ROM table incorporated in the gain compensation controller 9A, for indicating the relationships between the idle current variation ΔIdo of the power amplifier 7 and the bias voltage variation ΔV_{gg} of the power amplifier 7; 63 designates a ROM table incorporated in the gain compensation controller 9A, for indicating the relationships between the idle current variation ΔIdo of the power amplifier 7 and the gain variation ΔGain of the power amplifier 7; and 64 designates a ROM table incorporated in the gain compensation controller 9A, for indicating the relationships between the gain variation ΔGain and the control voltage variation ΔVcnt of at least one of the variable gain amplifiers.

Since the remaining components of the embodiment 4 of the radio transmitter are the same as those of the embodiment 3, the description thereof is omitted here.

Next, the operation of the present embodiment 4 will be described.

Referring to the ROM table 61, the gain compensation controller 9A derives the idle current variation ΔIdo of the power amplifier 7 corresponding to the desired output power level, first.

Subsequently, referring to the ROM table 62, the gain compensation controller 9A derives the bias voltage variation ΔVgg from the idle current variation, and supplies it to the power amplifier bias voltage controller 8A.

Then, referring to the ROM table 63, the gain compensation controller 9A derives the gain variation ΔGain of the power amplifier 7 from the idle current variation ΔIdo. It also refers to the ROM table 64 to derive the control voltage variation ΔVcnt of at least one of the variable gain power amplifiers from the gain variation ΔGain, and supplies it to the variable gain power amplifier gain controller 10.

Since the remaining operation is the same as that of the foregoing embodiment 3, the description thereof is omitted here.

The ROM tables 62, 63 and 64 record in advance the information obtained by measuring the idle current variation versus the bias voltage variation of the power amplifier 7, the idle current variation versus the gain variation of the power amplifier 7, and the gain variation versus the control voltage variation of the variable power amplifier.

Although the ROM tables in the present embodiment 4 store the relationships between the variations of the characteristic values, they can store the relationships between the absolute values of the characteristic values, instead.

In addition, although the present embodiment 4 utilizes the bias voltage Vgg of the power amplifier 7, the bias voltage Vdd can be used instead.

Although the present embodiment 4 captures the control voltages from the bias voltage using the ROM tables 61-64, this is not essential. For example, the gain compensation controller 9A can calculate the control voltages from the bias voltage according to functions approximating the relationships between the characteristic values instead of incorporating the ROM tables 61-64.

The functions can be obtained by measuring the relationships between the idle current variation and the bias voltage variation, between the idle current variation and the gain variation, and between the gain variation and the control voltages in advance, and by carrying out the function approximation of the measured results. The function approximation can eliminate the ROM tables 61-64, and hence reduce the capacity of the ROM necessary for the present system.

As described above, since the present embodiment 4 prestores the information about the relationships between the characteristic values using the ROM tables or functions, it can eliminate the signal extraction detector for detecting the output power of the power amplifier 7 and the circuit for feeding the output power back to the control voltage during the output power control. Thus, in addition to the advantages of the embodiment 3, it offers an advantage of being able to simplify the configuration of the system, and to shorten the control time.

Besides, although it is usually difficult to configure a wide dynamic range detector, since the present embodiment 4 does not require the detector, it offers an advantage of being able to carry out the output power control over a wide dynamic range at high accuracy.

### EMBODIMENT 5

The present embodiment 5 of the radio transmitter in accordance with the present invention is configured such that it varies the bias voltage of the power amplifier 7 stepwise in response to the desired output power level in the foregoing embodiments 1-4.

Fig. 7 is a diagram illustrating an example of measured results of the relationships between the bias voltage variation ΔVgg and the dispersion of the gain variation of the power amplifier 7 in the present embodiment 5.

The present embodiment 5 varies the bias voltage of the power amplifier 7 stepwise in response to the desired output power level. More specifically, as illustrated in Fig. 7, it varies the bias voltage stepwise from the reference value Vref to a first bias voltage Vggl, to a second bias voltage Vgg2, and to a third bias voltage Vgg3. Thus, as compared with the case where the bias voltage is greatly reduced once as illustrated in Fig. 4, the present embodiment 5 can further reduce the individual dispersion of the gain variation and the individual dispersion of the temperature characteristic due to the change in the bias voltage of the power amplifier 7 and involved in the output power control for the power consumption reduction.

As described above, since the present embodiment 5 varies the bias voltage of the power amplifier at least at two steps, it offers an advantage of being able to reduce the individual dispersion of the gain variation and the individual dispersion of the temperature characteristic due to the change in the bias voltage of the power amplifier 7.

Although the bias voltage Vgg is varied stepwise in Fig. 7, this is not essential. For example, the bias voltage Vdd or the idle current can be varied stepwise, offering similar advantages.

## Claims

1. A radio transmitter comprising:
a power amplifier (7);
a variable gain amplifier connected in series with said power amplifier (21, 3, 4, 6);
bias voltage apply means (11) for applying a bias voltage to said power amplifier;
gain control means (10) for controlling a gain of said variable gain amplifier;
bias voltage control means (8) for controlling the bias voltage of said power amplifier; and
compensation means (8, 9) for compensating a gain variation of said power amplifier involved in controlling the bias voltage of said power amplifier by controlling the gain of said variable gain amplifier.

2. The radio transmitter according to claim 1, wherein said bias voltage control means (8) controls the bias voltage of said power amplifier (7) in response to desired output power of said power amplifier.

3. The radio transmitter according to claims 1 - 2, in particular to claim 2, wherein said compensation means (8, 9) comprises information about relationships between the desired output power of said power amplifier and the bias voltage of said power amplifier, and information about relationships between the bias voltage of said power amplifier and the gain of said variable gain amplifier.

4. The radio transmitter according to claims 1 - 3, in particular claim 1, wherein said compensation means (8, 9) compensates for the gain variation of said power amplifier (7) involved in controlling the bias voltage of said power amplifier, by deriving idle current of said power amplifier from desired output power of said power amplifier, by deriving the bias voltage of said power amplifier, by deriving the bias voltage of said power amplifier and the gain of said variable gain amplifier from the idle current of said power amplifier, and by supplying said bias voltage control means and said gain control means with the bias voltage and the gain derived.

5. The radio transmitter according to claims 1 - 4, in particular to claim 4, wherein said compensation means (8, 9) comprises information about relationships between the desired output power of said power amplifier and the idle current of said power amplifier, information about relationships between the idle current of said power amplifier and the gain of said variable gain amplifier, and information about relationships between the idle current of said power amplifier and the bias voltage of said power amplifier.

6. The radio transmitter according to claims 1 - 5, in particular to claims 2 - 5, wherein the bias voltage of aid power amplifier (7) is varied at least at two steps.
